# EUROPEAN PATENT APPLICATION

(11) **EP 4 525 571 A1**
(43) Date of publication of application: **19.03.2025**
(21) Application number: 23869704.9
(22) Date of filing: 05.06.2023
(51) Int. Cl.: H05K 7/14

(54) **SERVER**

(30) Priority: 26.09.2022 CN 202211172185
(71) Applicant: xFusion Digital Technologies Co., Ltd., Zhengzhou, Henan 450000 (CN)
(72) Inventor: RAN, Maoliang, Zhengzhou, Henan 450000 (CN); LIU, Honghui, Zhengzhou, Henan 450000 (CN); ZHAO, Huijing, Zhengzhou, Henan 450000 (CN); PENG, Xiaowei, Zhengzhou, Henan 450000 (CN)
(74) Representative: MERH-IP Matias Erny Reichl Hoffmann Patentanwälte PartG mbB
(86) International application number: PCT/CN2023/098430
(87) International publication number: WO 2024/066452

(57) **Abstract**

Embodiments of this application provide a server, including a chassis, a storage module, a main control module, a first module, and a second module. The chassis has an inner cavity, and the inner cavity of the chassis sequentially includes a first area, a second area, and a third area in a length direction of the chassis. The storage module and the first module are disposed in the first area of the chassis, the storage module and the first module are spaced apart in a height direction of the chassis, the first module includes a first function card, and a width direction of the first function card is disposed in the height direction of the chassis. The main control module is disposed in the second area of the chassis. The second module is disposed in the third area of the chassis, the second module includes a second function card, and a height direction of the second function card is disposed in the height direction of the chassis. The server provided in this application has advantages of increasing a quantity of function cards in the inner cavity of the chassis, and being beneficial for the server to perform large-scale computing.

## Description

This application claims priority to Chinese Patent Application No. 202211172185.5, filed with the China National Intellectual Property Administration on September 26, 2022 and entitled "SERVER", which is incorporated herein by reference in its entirety.

### TECHNICAL FIELD

Embodiments of this application relate to the field of server technologies, and in particular, to a server.

### BACKGROUND

In a server product, a GPU (Graphics Processing Unit) server, that is a GPU-based server and applied to a plurality of scenarios such as video decoding, deep learning, and scientific computing, can provide fast, stable, and flexible computing services.

In a related technology, a GPU server may include a housing, and a CPU (Central Processing Unit) module and a GPU module may be disposed in an inner cavity of the housing. A serial part of a program runs on the CPU module, and a parallel part of the program runs on the GPU module.

However, density of GPUs in the inner cavity of the housing is limited by size of the housing, which cannot better meet a requirement of ultra-large computing.

### SUMMARY

Embodiments of this application provide a server, to resolve a problem that a requirement of ultra-large computing cannot be better met because density of GPUs in an inner cavity of a chassis is limited by the size of the chassis.

To implement the foregoing objective, the embodiments of this application provide the following technical solutions.

According to an aspect of the embodiments of this application, a server is provided. The server includes a chassis with an inner cavity. A storage module, a main control module, a first module, and a second module are disposed in the inner cavity of the chassis. A height of the chassis is not less than 4U, and the chassis has the inner cavity which sequentially includes a first area, a second area, and a third area in the length direction. The storage module and the first module are disposed in the first area of the chassis, and the storage module and the first module are spaced apart in the height direction of the chassis, wherein the first module includes a first function card, and a width direction of the first function card is disposed in the height direction of the chassis. The main control module is disposed in the second area of the chassis. The second module which includes a second function card is disposed in the third area of the chassis, and a height direction of the second function card is disposed in the height direction of the chassis.

The server provided in the embodiments of this application includes the chassis, and the inner cavity of the chassis sequentially includes the first area, the second area, and the third area in the length direction of the chassis. The storage module and the first module are disposed in the first area, and the storage module and the first module are spaced apart in the height direction of the chassis, wherein the first module includes the first function card, and the width direction of the first function card is disposed in the height direction of the chassis. The main control module is disposed in the second area. The second which includes the second function card module is disposed in the third area, and the height direction of the second function card is disposed in the height direction of the chassis. Therefore, it is conducive to increasing a quantity of function cards in the limited inner cavity of the chassis, which is beneficial for the server to perform large-scale computing.

In a possible implementation, the chassis has a first window and a second window, both of the first window and the second window are in communication with the inner cavity of the chassis, the first window is close to the first area, and the second window is close to the third area; a through-flow space used for flowing of cooling fluid is disposed outside at least one of the storage module and the first module; and the cooling fluid flows into the inner cavity of the chassis through the first window, flows toward the main control module through the through-flow space, and flows out of the inner cavity of the chassis through the second window.

In a possible implementation, in the case of that the through-flow space used for flowing of the cooling fluid is disposed outside the storage module, the storage module includes a storage adapter board and a storage, and the adapter board is located on a side that is of the storage and that is in the height direction of the chassis, and electrically connects the main control module to the storage.

In a possible implementation, there are a plurality of storages, the plurality of storages are spaced apart in a width direction of the chassis, and the storage module and the through-flow space are sequentially arranged in the height direction of the chassis.

In a possible implementation, in the case of that the through-flow space used for flowing of the cooling fluid is disposed outside the first module, the first module includes a plurality of first function cards, the plurality of first function cards are spaced apart in the height direction of the chassis, and the first module and the through-flow space are sequentially arranged in a width direction of the chassis.

In a possible implementation, a length direction of the first function card intersects with the length direction of the chassis.

In a possible implementation, an included angle between the length direction of the first function card and the width direction of the chassis is between 10° and 45°.

In a possible implementation, the first module includes a first adapter board, and the first adapter board is disposed at one end of the length direction of the first function card, and electrically connects the plurality of first function cards to the main control module.

In a possible implementation, a fan module is included, which is closer to the first window than the main control module, the fan module includes a fan adapter board and a fan, and the fan adapter board is disposed at one end that is of the fan and that is in the height direction of the chassis, and electrically connects the fan to the main control module.

In a possible implementation, the second module is located on a side that is of the main control module and that is close to the second window; the second module and the main control module are spaced apart in the width direction of the chassis; or at least a part of the second module is located on a side that is of the main control module and that is close to the second window, and at least a part of the second module and the main control module are spaced apart in the width direction of the chassis.

In addition to the foregoing technical problem resolved in the embodiments of this application, technical features constituting the technical solutions, and beneficial effects brought by the technical features of these technical solutions, other technical problems that can be resolved in the embodiments of this application, other technical features included in the technical solutions, and beneficial effects brought by these technical features are further described in detail in specific implementations.

### BRIEF DESCRIPTION OF DRAWINGS

The accompanying drawings, which are incorporated herein by reference and constitute a part of the specification, illustrate embodiments that conform to this application, and are used together with the specification to explain the principle of this application.
FIG. 1 is a top view of a first server according to an embodiment of this application;
FIG. 2 is a front view of the server shown in FIG. 1;
FIG. 3 is a rear view of the server shown in FIG. 1;
FIG. 4 is a top view of a part of a second server according to an embodiment of this application;
FIG. 5 is a front view of a part of a third server according to an embodiment of this application;
FIG. 6 is a top view of a part of a fourth server according to an embodiment of this application;
FIG. 7 is a front view of the server shown in FIG. 6;
FIG. 8 is a top view of a part of a fifth server according to an embodiment of this application;
FIG. 9 is a front view of the server shown in FIG. 8;
FIG. 10 is a top view of a part of a sixth server according to an embodiment of this application;
FIG. 11 is a front view of the server shown in FIG. 10;
FIG. 12 is a front view of a seventh server according to an embodiment of this application; and
FIG. 13 is a front view of an eighth server according to an embodiment of this application.

Reference numerals:
100-chassis; 110-first window; 120-second window; 130-bottom wall; 140-top wall; 150-front wall; 160-rear wall; 170-left wall; 180-right wall; 190-inner cavity; 191-first area; 192-second area; 193-third area;
200-first module; 210-first function card; 220-first adapter board;
300-second module; 310-second function card; 320-second adapter board;
400-main control module; 410-circuit board; 420-processing chip; 430-memory;
500-storage module; 510-storage; 520-storage adapter board;
600-through-flow space;
700-power module;
800-fan module; and 810-fan.

The foregoing accompanying drawings show clear embodiments of this application, which will be described in more detail later. These accompanying drawings and text descriptions are not intended to limit the scope of the concept of this application in any manner, but are intended to describe, with reference to specific embodiments, the concept of this application for a person skilled in the art.

### DESCRIPTION OF EMBODIMENTS

As described in the background, a server in a related technology has a problem that a requirement of ultra-large scale computing cannot be better met because density of GPUs in an inner cavity of a housing is limited by a size of the housing.

In view of this, the embodiments of this application provide a server, which includes a chassis. A first function card and a second function card are disposed in the inner cavity of the chassis. A width direction of the first function card is disposed in the height direction of the chassis, that is, the first function card is arranged in the inner cavity of the chassis in a horizontal direction. A height direction of the second function card is disposed in the height direction of the chassis, that is, the second function card is arranged in the inner cavity of the chassis in a longitudinal direction. Compared with a related technology, function cards with different arrangement manners are provided in the embodiments of this application, so that a quantity of function cards in a limited space are increased to be beneficial f or the server to perform large-scale computing.

To make the objectives, technical solutions, and advantages of the embodiments of this application clearer, the following clearly and comprehensively describes the technical solutions in the embodiments of this application with reference to the accompanying drawings in the embodiments of this application. Apparently, the described embodiments are some rather than all of the embodiments of this application.

Based on the embodiments of this application, all other embodiments obtained by a person of ordinary skill in the art without creative efforts fall within the protection scope of this application. In a case of no conflict, features in the following different embodiments may be mutually combined.

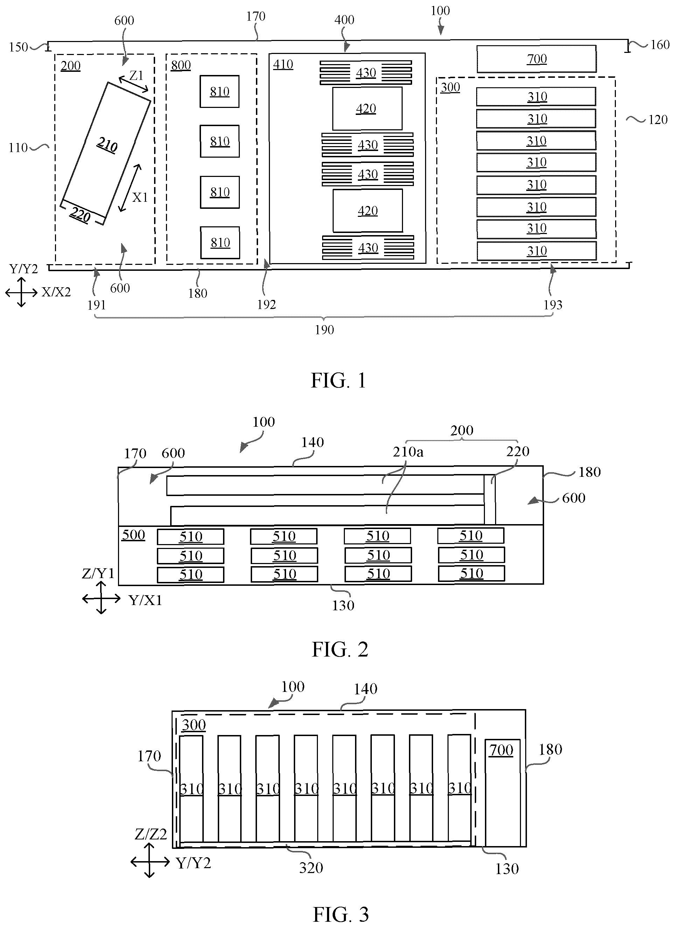

FIG. 1 is a schematic diagram of a server according to an embodiment of this application. Refer to FIG. 1. The server provided in this embodiment of this application may include a chassis 100 with an inner cavity. A first module 200, a second module 300, a main control module 400, a storage module 500, and a power module 700 may be disposed in the inner cavity 190 of the chassis 100.

The chassis 100 may have a length direction X, a width direction Y, and a height direction Z. In addition, the chassis 100 may have a left wall 170 and a right wall 180 that are disposed opposite to each other in the width direction Y of the chassis 100. The chassis 100 may have a front wall 150 and a rear wall 160 that are disposed opposite to each other in the length direction X of the chassis 100, and the inner cavity 190 of the chassis 100 may sequentially include a first area 191, a second area 192, and a third area 193 in the length direction of the chassis 100. In addition, FIG. 2 is a front view of the server shown in FIG. 1. Refer to FIG. 2. The chassis 100 of the server may have a bottom wall 130 and a top wall 140 that are disposed opposite to each other in the height direction Z of the chassis 100. When the server operates, a wall surface of the chassis 100 that faces a support surface may be the bottom wall 130 of the chassis 100, and a wall surface t of the chassis 100 that faces away from the support surface may be the top wall 140 of the chassis 100. It may be understood that FIG. 1 is a top view of the server in which the top wall 140 of the chassis 100 is removed.

Refer to FIG. 1 and FIG. 2. The first module 200 may include a first function card 210. The first function card 210 may be a prolate electronic element, for example, a GPU card. A width direction (a thickness direction) Y1 of the first function card 210 is less than a height direction Z1 of the first function card 210, and the height direction Z1 of the first function card 210 is less than a length direction X1 of the first function card 210.

In addition, the width direction Y1 of the first function card 210 may be disposed in the height direction Z of the chassis 100. That is, as shown in FIG. 1, the plane formed by the length direction X1 and the height direction Z1 of the first function card 210 may be parallel to a plane formed by the length direction X and the width direction Y of the chassis 100 (that is, the top wall 140 or the bottom wall 130 of the chassis 100). In other words, the first function card 210 may be parallel to the bottom wall 130 or the top wall 140 of the chassis 100 in the length direction Y1 and the height direction Z1 of the first function card 210. In other words, the first function card 210 is horizontally arranged in the inner cavity 190 of the chassis 100.

In this way, the width direction Y1 of the first function card 210 is a shortest edge of the first function card 210. Because the shortest edge is disposed in the height direction Z of the chassis 100, a height occupied by the first function card 210 in the chassis 100 is short, so that spaces for mounting electronic elements (for example, a GPU card) can be formed on two sides that are of the first function card 210 and that are in the height direction Z of the chassis 100.

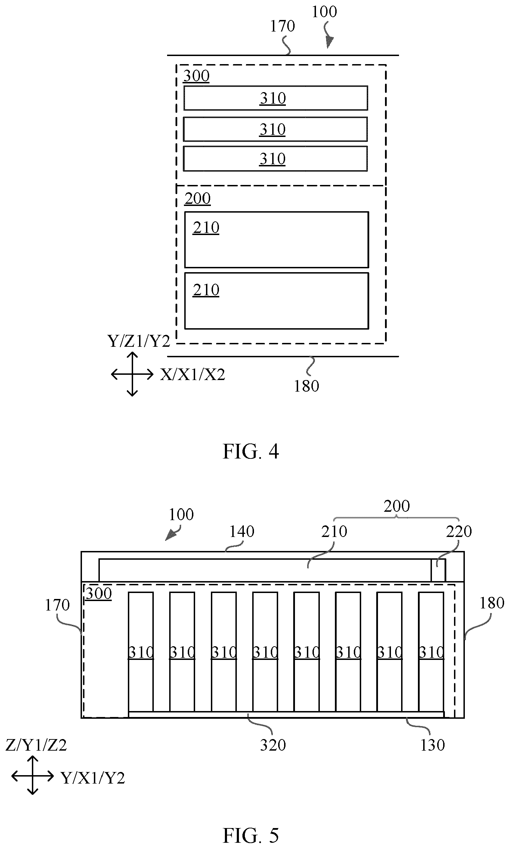

Refer to FIG. 2. For example, the first module 200 may include one or more first function cards 210. In the case of the first module 200 includes a plurality of first function cards 210, at least two of a plurality of first function cards 210 may be spaced apart in the height direction Z of the chassis 100. Still refer to FIG. 2. For another example, a mounting space may be formed between the first module 200 and the bottom wall 130 (or the top wall 140) of the chassis 100, and the storage module 500 may be disposed in the mounting space. That is, the first module 200 and the storage module 500 may be spaced apart in the height direction Z of the chassis 100. Refer to FIG. 5. For example, a mounting space may be formed between the first module 200 and the bottom wall 130 (or the top wall 140) of the chassis 100, and the second module 300 may be disposed in the mounting space. That is, the second module 300 and the first module 200 may be spaced apart in the height direction Z of the chassis 100.

It should be noted that there are standard sizes for a height and a width of the server in the server field. The height of the server may be a value, for example, 1U (44.45 mm), 2U (88.9 mm), 4U (177.8 mm), or 6U (266.7 mm). The width of the server may be 482.6 mm. There may be two specifications for a GPU card. A first specification is a height of 111.15 mm × a length of 312.00 mm × a width of 40 mm, and a second specification is a height of 68.9 mm × a length of 167.65 mm × a width of 20 mm. If the first function card 210 is a GPU card, that is, a width direction of the GPU card is disposed in the height direction Z of the chassis 100, a space of 1U may accommodate one first function card 210 of the first specification, two first function cards 210 of the second specification, or two groups of first function cards 210 of the second specification that are spaced apart in the width direction Y of the chassis 100, and each group of the second specification may include two first function cards 210 of the second specification that are spaced apart in the height direction Z of the chassis 100. A person skilled in the art may simply derive a quantity of first function cards 210 that can be accommodated in a space of 2U or a larger space. Details are not described herein.

FIG. 3 is a rear view of the server shown in FIG. 1. Refer to FIG. 1 and FIG. 3. The second module 300 may include a second function card 310. The second function card 310 may be a prolate electronic element, for example, a GPU card. A width direction (a thickness direction) Y2 of the second function card 310 is less than a height direction Z2 of the second function card 310, and the height direction Z2 of the second function card 310 is less than a length direction X2 of the second function card 310.

In addition, the height direction Z2 of the second function card 310 may be disposed in the height direction Z of the chassis 100. That is, the width direction Y1 of the first function card 210 is perpendicular to the width direction Y2 of the second function card 310. As shown in FIG. 1, a plane formed by the length direction X2 of the second function card 310 and the width direction Y2 of the second function card 310 may be parallel to the plane formed by the length direction X of the chassis 100 and the width direction Y of the chassis 100 (that is, the top wall 140 or the bottom wall 130 of the chassis 100). In other words, the height direction Z2 of the second function card 310 is perpendicular to the bottom wall 130 or the top wall 140 of the chassis 100. In other words, the second function card 310 is longitudinally arranged in the inner cavity 190 of the chassis 100.

As shown in FIG. 1, the width direction Y2 of the second function card 310 may be disposed in the width direction Y of the chassis 100, so that a width occupied by the second function card 310 in the chassis 100 is short, and spaces for mounting electronic elements (for example, a GPU card) can be formed on two sides that are of the second function card 310 and that are in the width direction Y of the chassis 100. Refer to FIG. 1. For example, the second module 300 may include one or more second function cards 310. In the case of the second module 300 includes a plurality of second function cards 310, at least two of the plurality of second function cards 310 may be spaced apart in the width direction Y of the chassis 100. Still refer to FIG. 1. For another example, a mounting space may be formed between the second module 300 and the left wall 170 (or the right wall 180) of the chassis 100, and the power module 700 may be disposed in the mounting space. That is, the second module 300 and the power module 700 may be spaced apart in the width direction Y of the chassis 100. Refer to FIG. 4. For example, a mounting space may be formed between the second module 300 and the left wall 170 (or the right wall 180) of the chassis 100, and the first module 200 may be disposed in the mounting space. That is, the first module 200 and the second module 300 may be spaced apart in the width direction Y of the chassis 100. The length direction X2 of the second function card 310 of the second module 300 and the length direction X1 of the first function card 210 of the first module 200 may be disposed in the length direction X of the chassis 100.

It should be noted that there are standard sizes for a height and a width of the server in the server field. The height of the server may be a value, for example, 1U (44.45 mm), 2U (88.9 mm), 4U (177.8 mm), or 6U (266.7 mm). The width of the server may be 482.6 mm. There may be two specifications for a GPU card. A first specification is a height of 111.15 mm × a length of 312.00 mm × a width of 40 mm, and a second specification is a height of 68.9 mm × a length of 167.65 mm × a width of 20 mm. If the second function card 310 is a GPU card, that is, the width direction of the GPU card is disposed in the width direction Y of the chassis 100, a space with a height of 4U or a larger height may accommodate a plurality of second function cards 310 of the first specification or two second function cards 310 of the second specification that are spaced apart in the width direction of the chassis 100.

In conclusion, compared with a related technology, in the server provided in this embodiment of this application, the first function card 210 and the second function card 310 may be disposed in the inner cavity 190 of the chassis 100, and the width direction Y1 of the first function card 210 is perpendicular to the width direction Y2 of the second function card 310, so that diversity of function card arrangement is improved. In addition, the space for mounting the electronic elements (for example, the GPU card) can be formed on the two sides that are of the first function card 210 and that are in the height direction Z of the chassis 100, and the space for mounting the electronic elements (for example, the GPU card) can be formed on the two sides that are of the second function card 310 and that are in the length direction X (or the width direction Y) of the chassis 100, so that a quantity of electronic elements such as the GPU card in the limited inner cavity 190 of the chassis 100 is increased to be beneficial for the server to perform large-scale computing.

The following describes several possible arrangement manners of the first module 200 and the second module 300.

Refer to FIG. 1. In a possible arrangement manner of the first module 200 and the second module 300, the first module 200 and the second module 300 are spaced apart in the length direction X of the chassis 100. That is, there is a specific spacing between the first module 200 and the second module 300 in the length direction X of the chassis 100, so that the first module 200 and the second module 300 are arranged in the length direction X of the chassis 100.

Refer to FIG. 4. In another possible arrangement manner of the first module 200 and the second module 300, the first module 200 and the second module 300 are spaced apart in the width direction Y of the chassis 100. That is, there is a specific spacing between the first module 200 and the second module 300 in the width direction Y of the chassis 100, so that the first module 200 and the second module 300 are arranged in the width direction Y of the chassis 100. Further, both the length direction X2 of the second function card 310 of the second module 300 and the length direction X1 of the first function card 210 of the first module 200 may be disposed in the length direction X of the chassis 100.

Refer to FIG. 5. In still another possible arrangement manner of the first module 200 and the second module 300, the first module 200 and the second module 300 are spaced apart in the height direction Z of the chassis 100. That is, there is a specific spacing between the first module 200 and the second module 300 in the height direction Z of the chassis 100, so that the first module 200 and the second module 300 are arranged in the height direction Z of the chassis 100.

It should be noted that the number of first modules 200 may be one or more. The number of the second module 300 may also be one or more. In the case of the number of the first module 200 and the second module 300 is one, any of the above-mentioned three ways may be used to arrange the first module 200 and the second module 300. In the case of the number of at least one of the first module 200 and the second module 300 is multiple, the arrangement of the first module 200 and the second module 300 may be a combination of any two of the above-mentioned three arrangements; or the arrangement of the first module 200 and the second module 300 may include the three arrangements mentioned above.

In addition, various cooling manners such as air cooling, liquid cooling, and LAAC (Liquid Assisted Air Cooling) may be used for the electronic elements in the inner cavity 190 of the chassis 100 of the server provided in this embodiment of this application.

Refer to FIG. 1. In the case of that air cooling is used, the chassis 100 may have a first window 110 and a second window 120, and both the first window 110 and the second window 120 may be connected with the inner cavity 190 of the chassis 100. It may be understood that most modules in the inner cavity 190 of the chassis 100 are spaced apart in the length direction X of the chassis 100. In this case, to implement heat exchange between the electronic elements in the inner cavity 190 of the chassis 100 and cooling fluid, the first window 110 and the second window 120 may be disposed at two ends of the chassis 100 in the length direction. For example, in FIG. 1, the first window 110 may be disposed on the front wall 150 of the chassis 100 and run through the front wall 150 of the chassis 100, and the second window 120 may be disposed on the rear wall 160 of the chassis 100 and run through the rear wall 160 of the chassis 100. The first window 110 may be defined as an inflow end of the chassis 100, and the second window 120 may be defined as an outflow end of the chassis 100. That is, the cooling fluid may flow into the inner cavity 190 of the chassis 100 through the first window 110 and flow out of the inner cavity 190 of the chassis 100 through the second window 120.

The main control module 400 may include a circuit board 410, processing chips 420, for example, CPUs, and memories 430. To reduce heat of the processing chip 420, a heat sink that directly contacts the processing chip 420 for heat transfer or contacts the processing chip 420 by using a thermally conductive material for heat transfer may be disposed outside the processing chip 420. To improve a cooling effect of air cooling on the processing chip 420, optionally, a side that is of the processing chip 420 or the heat sink and that is close to the first window 110 may not be shielded by an electronic element, so that air flowing into the inner cavity 190 of the chassis 100 through the first window 110 can directly flow toward the processing chip 420 or the heat sink. In this way, the processing chip 420 is less affected by cascade heating, and cooling efficiency is further improved.

Refer to FIG. 1 and FIG. 2 and FIG. 6 to FIG. 12. To implement a cooling effect of the main control module 400, optionally, at least one of the storage module 500 and the first module 200 may be located on a side that is of the main control module 400 and that is close to the first window 110, and a through-flow space 600 used for flowing of the cooling fluid may be disposed outside at least one of the storage module 500 and the first module 200. The cooling fluid may flow into the inner cavity 190 of the chassis 100 through the first window 110, flow toward the main control module 400 through the through-flow space 600, and flow out of the inner cavity 190 of the chassis 100 through the second window 120.

It should be noted that a plurality of external interfaces of the server are usually disposed on the front wall 150 of the chassis 100 during design of the server. The first window 110 used for the cooling fluid to flow into the inner cavity 190 of the chassis 100 is disposed on the front wall 150 of the chassis 100. Because the width 482.6 mm of the chassis 100 is greater than the height (1U, 2U, 4U, 6U, or the like) of the chassis 100, these external interfaces are usually spaced apart in the width direction Y of the chassis 100. That is, these external interfaces occupy a height of one or more layers of the chassis 100. In the case of a layout of electronic elements on the side that is of the main control module 400 and that is close to the first window 110 is designed, a specific height needs to be reserved on the chassis 100 for the external interfaces.

The storage module 500 may include one or more storages 510. A width of the storage 510 and a width of the first function card 210 of the first module 200 are short, and the width of the storage 510 and the width of the first function card 210 may be disposed in the height direction Z of the chassis 100. Therefore, the storage module 500 and/or the first module 200 are disposed on the side that is of the main control module 400 and that is close to the first window 110. This can be conducive to reserving the specific height on the chassis 100 for the external interfaces. In addition, the height direction Z2 of the second function card 310 is disposed in the height direction Z of the chassis 100. If the second function card 310 is arranged on the side that is of the main control module 400 and that is close to the first window 110, the second function card 310 occupies an arrangement space of the external interfaces.

In addition, the foregoing through-flow space 600 may be formed in the following possible implementations.

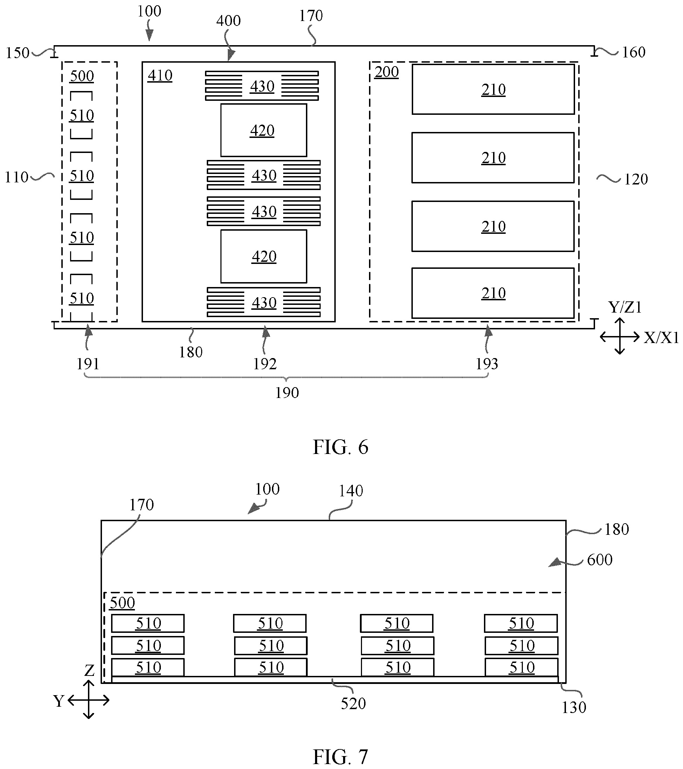

FIG. 6 is a top view of a part of a fourth server according to an embodiment of this application, and FIG. 7 is a front view of the server shown in FIG. 6. Refer to FIG. 6 and FIG. 7. In a possible implementation of forming the through-flow space 600, the first module 200 and the main control module 400 are spaced apart in the width direction Y of the chassis 100; or as shown in FIG. 6, the first module 200 is located on a side that is of the main control module 400 and that is close to the second window 120. That is, the main control module 400 may be located in the second area 192 of the chassis 100 as shown in FIG. 6, the first module 200 may be located in the third area 193 of the chassis 100 as shown in FIG. 6.

In addition, the storage module 500 may be located on the side that is of the main control module 400 and that is close to the first window 110. That is, the storage module 500 may be located in the first area 191 of the chassis 100. In addition, as shown in FIG. 7, the through-flow space 600 used for flowing of the cooling fluid is disposed outside the storage module 500, so that the cooling fluid flowing into the inner cavity 190 of the chassis 100 through the first window 110 can flow toward the main control module 400 through the through-flow space 600.

There may be one or more storage modules 500. Refer to FIG. 7. In the case of there is one storage module 500, there may be a preset spacing between the storage module 500 and an inner chassis wall of the chassis 100, so that the through-flow space 600 is formed. In the case of there are a plurality of storage modules 500, the plurality of storage modules 500 may be spaced apart in the height direction Z of the chassis 100 or spaced apart in the width direction Y of the chassis 100. The through-flow space 600 may be formed between a separate storage module 500 and the inner chassis wall of the chassis 100, or the through-flow space 600 may be formed between two adjacent storage modules 500.

In addition, the storage module 500 may include a storage bracket, a storage 510 (for example, a hard disk), and a storage adapter board 520. The storage bracket may have one or more accommodating spaces, and the storage 510 may be placed in the accommodating space in a one-to-one correspondence. One end that is of the storage bracket and that is away from the main control module 400 may have one or more hot-swap ports, and an opening corresponding to the hot-swap port may be disposed on a chassis wall of the chassis 100, so that a corresponding hot-swap port can be exposed through the opening on the wall of the chassis 100. The storage adapter board 520 may be electrically connected between the storage 510 and the main control module 400, and may have a storage 510 disk position. The storage 510 disk position may have a storage 510 interface, and the storage 510 interface may be adaptively electrically connected to an SAS (Serial Attached SCSI) interface, an SCSI (Small Computer System Interface), or a SATA (Serial Advanced Technology Attachment, serial storage 510) interface of the storage 510.

In addition, to prevent the storage adapter board 520 from obstructing flowing of the cooling fluid, as shown in FIG. 7, the storage adapter board 520 may be disposed on a side that is of the storage 510 and that is in the height direction Z of the chassis 100. The storage adapter board 520 may be fixedly connected to the top wall 140 or the bottom wall 130 of the chassis 100 by screws.

Further, to ensure a quantity of storages 510 while increasing a volume of the through-flow space 600, optionally, the storage module 500 may include a plurality of storages 510. As shown in FIG. 6 and FIG. 7, at least two of the plurality of storages 510 may be spaced apart in the width direction Y of the chassis 100, so that the quantity of storages 510 is increased in the width direction Y of the chassis 100. In addition, as shown in FIG. 7, the storage module 500 and the through-flow space 600 may be sequentially arranged in the height direction Z of the chassis 100, so that the main control module 400 is cooled in the height direction Z of the chassis 100. In addition, as shown in FIG. 7, in the case of that the height of the chassis 100 is sufficient, at least two of the plurality of storages 510 may be spaced apart in the height direction Z of the chassis 100.

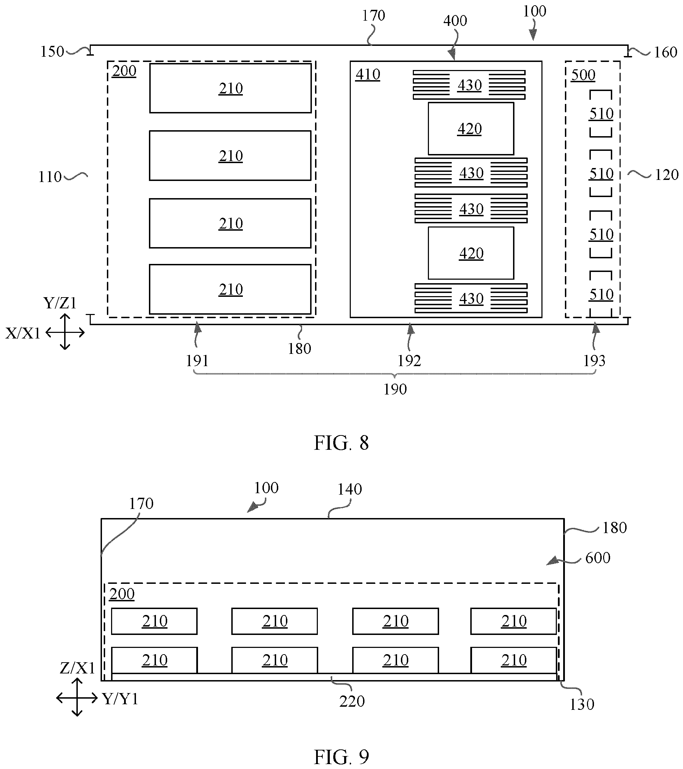

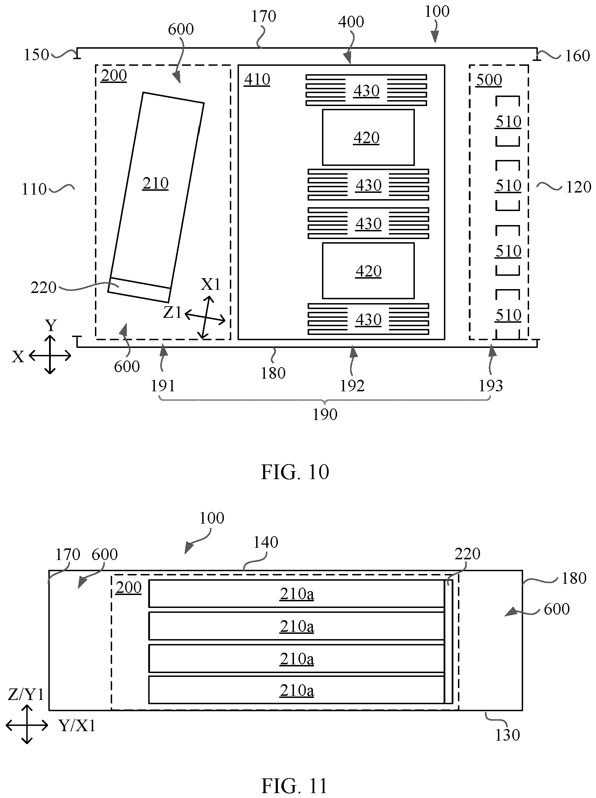

FIG. 8 is a top view of a part of a fifth server according to an embodiment of this application. FIG. 9 is a front view of the server shown in FIG. 8. FIG. 10 is a top view of a part of a sixth server according to an embodiment of this application. FIG. 11 is a front view of the server shown in FIG. 10. Refer to FIG. 8, FIG. 9, FIG. 10, and FIG. 11. In another possible implementation of forming the through-flow space 600, the storage module 500 and the main control module 400 may be spaced apart in the width direction Y of the chassis 100; or as shown in FIG. 8 and FIG. 10, the storage module 500 may be located on the side that is of the main control module 400 and that is close to the second window 120. That is, the main control module 400 may be located in the second area 192 of the chassis 100 as shown in FIG. 8 and FIG. 10, and the storage module 500 may be located in the third area 193 of the chassis 100 as shown in FIG. 8 and FIG. 10.

In addition, the first module 200 may be located on the side that is of the main control module 400 and that is close to the first window 110. That is, as shown in FIG. 8 and FIG. 10, the first module 200 may be located in the first area 191 of the chassis 100. In addition, as shown in FIG. 9 and FIG. 11, the through-flow space 600 used for flowing of the cooling fluid may be disposed outside the first module 200. It can be seen from FIG. 8, FIG. 9, FIG. 10, and FIG. 11 that a part of the cooling fluid flowing into the inner cavity 190 of the chassis 100 through the first window 110 may flow through the first function card 210 of the first module 200 and then flow toward the main control module 400, and the remaining cooling fluid may directly flow toward the main control module 400 through the through-flow space 600.

There may be one or more first modules 200. In the case of there is one first module 200, there may be a preset spacing between the first module 200 and the inner chassis wall of the chassis 100, so that the through-flow space 600 is formed. In the case of t there are a plurality of first modules 200, the plurality of first modules 200 may be spaced apart in the height direction Z of the chassis 100 or spaced apart in the width direction Y of the chassis 100. The through-flow space 600 may be formed between a separate first module 200 and the inner chassis wall of the chassis 100, or the through-flow space 600 may be formed between two adjacent first modules 200.

In addition, the first module 200 may include one or more first function cards 210. As mentioned above, the width direction Y1 of the first function card 210 is disposed in the height direction Z of the chassis 100, so that the first function card 210 is horizontally arranged in the inner cavity 190 of the chassis 100. The length direction X1 and the height direction of the first function card 210 may be disposed in the following possible manners.

Refer to FIG. 8 and FIG. 9. For example, the height direction Z1 of the first function card 210 may be disposed in the width direction Y of the chassis 100, and the length direction X1 of the first function card 210 may be disposed in the length direction X of the chassis 100, so that the width occupied by the first function card 210 in the chassis 100 is short, and space for mounting electronic elements (for example, a GPU card) can be formed on two sides that are of the first function card 210 and that are in the width direction Y of the chassis 100. Refer to FIG. 8. For example, the first module 200 may include one or more first function cards 210. In the case of t the first module 200 includes a plurality of first function cards 210, at least two of the plurality of first function cards 210 may be spaced apart in the width direction Y of the chassis 100.

Further, refer to FIG. 9. The through-flow space 600 may be disposed at one end that is of the first module 200 and that is in the height direction Z of the chassis 100. That is, the through-flow space 600 and the first module 200 are sequentially disposed in the height direction Z of the chassis 100, so that the first function card 210 is disposed as many as possible in the width direction Y of the chassis 100, which also facilitates modular arrangement.

Refer to FIG. 10 and FIG. 11. For another example, the height direction Z1 of the first function card 210 may intersect with the width direction Y of the chassis 100, and the length direction X1 of the first function card 210 intersects with the length direction X of the chassis 100, to shorten a length occupied by the first function card 210 in the chassis 100, to further shorten a length of the chassis 100.

Further, refer to FIG. 11. The through-flow space 600 may be disposed at one or two ends that are of the first module 200 and that are in the width direction Y of the chassis 100. That is, the through-flow space 600 and the first module 200 are sequentially disposed in the width direction Y of the chassis 100. In this way, in the case of the first module 200 includes a plurality of first function cards 210, the plurality of first function cards 210 may be spaced apart in the height direction Z of the chassis 100, so that the first function card 210 is disposed as many as possible in the height direction Z of the chassis 100, which also facilitates modular arrangement.

Further, refer to FIG. 10. To increase area of the through-flow space 600, that is, to increase flow rate of the cooling fluid directly flowing toward the main control module 400, optionally, the length direction X1 of the first function card 210 may intersect with the width direction Y of the chassis 100. An included angle between the length direction X1 of the first function card 210 and the width direction Y of the chassis 100 may be between 10° and 45°.

For example, the first function card 210 may be a GPU card horizontally arranged in the inner cavity 190 of the chassis 100. There may be two specifications for a GPU card. A first specification is a height of 111.15 mm × a length of 312.00 mm × a width of 40 mm, and a second specification is a height of 68.9 mm × a length of 167.65 mm × a width of 20 mm. The width of the chassis 100 of the server is 482.6 mm.

Refer to FIG. 11. If the first function card 210 of the first module 200 is a GPU card of the first specification, because a standard width (482.6 mm) of the chassis 100 is greater than the length (312.00 mm) of the GPU card of the first specification and is less than twice (624 mm) of the length of the GPU card of the first specification, the GPU card of the first specification is not allowed to be placed on two sides of the length of the first function card 210 in FIG. 10 again. Therefore, in FIG. 11, four GPUs of the first specification may be placed in the chassis 100 of the height of 4U.

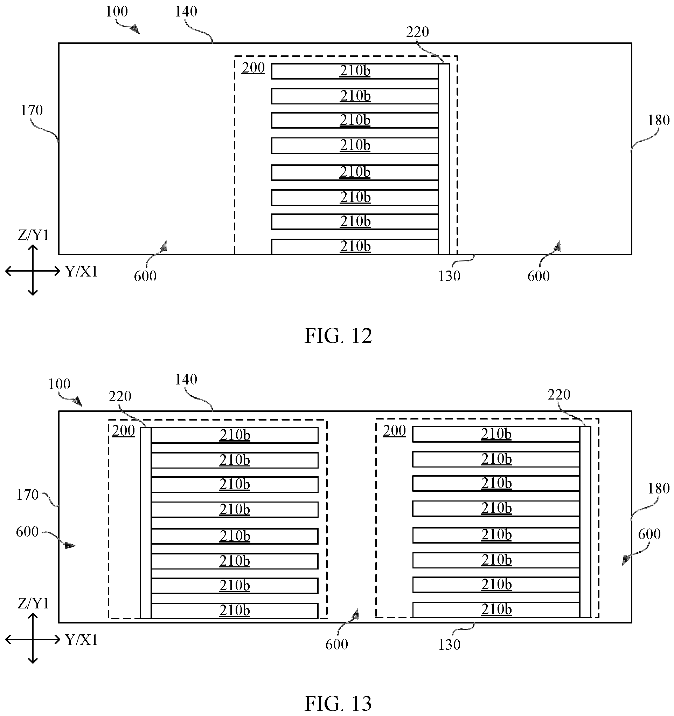

Refer to FIG. 12 and FIG. 13. If the first function card 210 of the first module 200 is a GPU card of the second specification, because the standard width (482.6 mm) of the chassis 100 is greater than twice the length (335.3 mm) of the GPU card of the second specification and is less than three times the length (502.95 mm) of the GPU card of the second specification, as shown in FIG. 12, two columns of first function cards 210 may be arranged in a parallel manner and the through-flow space 600 may be formed between the two columns of first function cards 210.

It should be noted that the first module 200 may further include a first bracket and a first adapter board 220. The first bracket may have one or more accommodating spaces, and the first function card 210 may be placed in the accommodating space in a one-to-one correspondence. The first adapter board 220 may be electrically connected between the first function card 210 and the main control module 400, and may have a first bayonet. The first function card 210 may be inserted into the first bayonet and be electrically connected to the first adapter board 220.

To prevent the first adapter board 220 from obstructing flowing of the cooling fluid, in the case of the first function card 210 is disposed as shown in FIG. 8, that is, in the case of the length direction X1 of the first function card 210 is disposed in the length direction X of the chassis 100, and the height direction Z1 of the first function card 210 is disposed in the width direction Y of the chassis 100, as shown in FIG. 9, the first adapter board 220 may be disposed on a side of the width direction Y1 of the first function card 210, that is, the first adapter board 220 may be disposed on a side that is of the first function card 210 and that is in the height direction Z of the chassis 100.

In addition, when the first function card 210 is disposed as shown in FIG. 10, that is, when the length direction X1 of the first function card 210 intersects with the length direction X of the chassis 100, as shown in FIG. 11 to FIG. 13, the first adapter board 220 may be disposed on a side of the length direction X1 of the first function card 210, that is, the first adapter board 220 may be disposed on a side that is of the first function card 210 and that is in the width direction Y of the chassis 100.

Refer to FIG. 1 and FIG. 2. In another possible implementation of forming the through-flow space 600, the storage module 500 and the first module 200 are located on the side that is of the main control module 400 and that is close to the first window 110, that is, the storage module 500 and the first module 200 are located in the first area 191 of the chassis 100. In addition, the through-flow space 600 may be disposed outside the first module 200; the through-flow space 600 may be disposed outside the storage module 500; or the through-flow space 600 may be disposed outside both the first module 200 and the storage module 500.

In addition, the storage module 500 and the first module 200 that are located on the side that is of the main control module 400 and that is close to the first window 110 may be spaced apart in the width direction Y of the chassis 100; or as shown in FIG. 2, the storage module 500 and the first module 200 that are located on the side that is of the main control module 400 and that is close to the first window 110 may be spaced apart in the height direction Z of the chassis 100, so that an arrangement structure of electronic elements in an inner cavity of the server is more compact.

It should be noted that there are standard sizes for a height and a width of the server. The height of the server may be a value, for example, 1U (44.45 mm), 2U (88.9 mm), 4U (177.8 mm), or 6U (266.7 mm). The width of the server may be 482.6 mm. There may be two specifications for a GPU card. A first specification is a height of 111.15 mm × a length of 312.00 mm × a width of 40 mm, and a second specification is a height of 68.9 mm × a length of 167.65 mm × a width of 20 mm. If the first function card 210 is a GPU card, a width direction of the GPU card is disposed in the height direction Z of the chassis 100. For example, in the case of the height of the chassis 100 is 4U, and as shown in FIG. 2, the storage module 500 and the first module 200 may be spaced apart in the height direction Z of the chassis 100, the storage module 500 may occupy a height of 1U, and the first module 200 may occupy a height of 3U; the storage module 500 may occupy a height of 2U, and the first module 200 may occupy a height of 2U; or the storage module 500 may occupy a height of 3U, and the first module 200 may occupy a height of 1U. Certainly, the height of the chassis 100 may alternatively be greater than 4U. In the case of the height of the chassis 100 is greater than 4U, there may be a plurality of combination forms for heights occupied by the first module 200 and the storage module 500, and the combination forms can be easily derived by a person skilled in the art with reference to the foregoing description. Details are not described herein.

As mentioned above, because the height direction Z2 of the second function card 310 of the second module 300 is disposed in the height direction Z of the chassis 100, the arrangement space of the external interfaces is occupied. Therefore, the second module 300 may not be disposed on the side that is of the main control module 400 and that is close to the first window 110. In this way, the second module 300 and the main control module 400 may be spaced apart in the width direction Y of the chassis 100; as shown in FIG. 1, the second module 300 may be disposed on the side that is of the main control module 400 and that is close to the second window 120, that is , the main control module 400 may be located in the second area 192 of the chassis 100 as shown in FIG. 1, and the second module 300 may be located in the third area 193 of the chassis 100 as shown in FIG. 1; or there are a plurality of second modules 300, at least one of the second modules 300 and the main control module 400 may be spaced apart in the width direction Y of the chassis 100, and at least one of the second modules 300 may be located on the side that is of the main control module 400 and that is close to the second window 120.

It should be noted that the second module 300 may further include a second bracket and a second adapter board 320. The second bracket may have one or more accommodating spaces, and the second function card 310 may be placed in the accommodating space in a one-to-one correspondence. The second adapter board 320 may be electrically connected between the second function card 310 and the main control module 400, and may have a second bayonet. The second function card 310 may be inserted into the second bayonet and be electrically connected to the second adapter board 320.

To prevent the second adapter board 320 from obstructing flowing of the cooling fluid, in the case of the second function card 310 is disposed as shown in FIG. 1 and FIG. 3, that is, when the length direction X2 of the second function card 310 is disposed in the length direction X of the chassis 100, the width direction Y2 of the second function card 310 is disposed in the width direction Y of the chassis 100, and the height direction Z2 of the second function card 310 is disposed in the height direction Z of the chassis 100, as shown in FIG. 3, the second adapter board 320 may be disposed on a side of the height direction Z2 of the second function card 310, that is, the second adapter board 320 may be disposed on a side that is of the second function card 310 and that is in the height direction Z of the chassis 100.

In addition, the power module 700 may supply power to the first module 200, the second module 300, and the main control module 400. In addition, the power module 700 may be a redundant power supply, and the power module 700 may be replaced under continuous power supply, which reduce downtime costs of power failure d, and improve high availability of the server. Refer to FIG. 1. To make a layout of the electronic elements in the inner cavity 190 of the chassis 100 more compact, the power module 700 and at least a part of the second module 300 may be located on the side that is of the main control module 400 and that is close to the second window 120, and the power module 700 and the second module 300 may be spaced apart in the width direction Y of the chassis 100.

In addition, to guide the cooling fluid, the server provided in this embodiment of this application may further include a fan module 800, and the fan module 800 may be disposed in the inner cavity 190 of the chassis 100. The fan module 800 may include a fan 810 adapter board and fans 810 arranged in an array. In the case of the fan module 800 is located on the side that is of the main control module 400 and that is close to the first window 110, to avoid obstructing flowing of the cooling fluid, the fan 810 adapter board may be disposed at one end that is of the fan 810 and that is in the height direction Z of the chassis 100, and may electrically connect the fan 810 to the main control module 400.

As shown in FIG. 1, there may be a plurality of fans 810, and at least two of the plurality of fans 810 may be spaced apart in the width direction Y of the chassis 100. In the case of the height of the chassis 100 is greater than twice or more than twice a height of a single fan 810, at least two of the plurality of fans 810 may be spaced apart in the height direction Z of the chassis 100.

In the embodiments of this application, unless otherwise specified and limited, terms such as "mount", "communicate", "connect", and "fasten" should be understood in a broad sense, for example, may be fixed connections, detachable connections, or integration; may be direct connections, or indirect connections implemented by using intermediate media; or may be communication between two elements or interaction relationships between two elements. A person of ordinary skill in the art may understand specific meanings of the foregoing terms in the embodiments of this application based on a specific case.

In the descriptions of the specification, descriptions made with reference to the terms such as "an embodiment", "some embodiments", "schematic embodiment", "for example", "specific example", or "some examples" refer to that specific characteristics, structures, materials, or features that are described in combination with the embodiment or example are included in at least one embodiment or example of the present disclosure. In the specification, schematic expressions of the foregoing terms do not necessarily refer to a same embodiment or example. In addition, the specific characteristics, structures, materials, or features described may be combined in an appropriate manner in any one or more embodiments or examples.

Finally, it should be noted that the foregoing embodiments are merely intended for describing the technical solutions of this application, instead of limiting this application. Although this application is described in detail with reference to the foregoing embodiments, a person of ordinary skill in the art should understand that modifications may still be made to the technical solutions described in the foregoing embodiments or equivalent replacements may still be made to some or all technical features thereof. However, these modifications or replacements do not make the essence of the corresponding technical solutions depart from the scope of the technical solutions in the embodiments of this application.

## Claims

1. A server, comprising a chassis, a storage module, a main control module, a first module, and a second module, wherein
the chassis has an inner cavity, and the inner cavity of the chassis sequentially comprises a first area, a second area, and a third area in a length direction of the chassis;
the storage module and the first module are disposed in the first area of the chassis, the storage module and the first module are spaced apart in a height direction of the chassis, the first module comprises a first function card, and a width direction of the first function card is disposed in the height direction of the chassis;
the main control module is disposed in the second area of the chassis; and
the second module is disposed in the third area of the chassis, the second module comprises a second function card, and a height direction of the second function card is disposed in the height direction of the chassis.

2. The server according to claim 1, wherein the chassis has a first window and a second window, the first window and the second window are in communication with the inner cavity of the chassis, the first window is close to the first area, and the second window is close to the third area;
the outside of at least one of the storage module and the first module has a flow space for cooling fluid to flow; and
the cooling fluid flows into the inner cavity of the chassis through the first window, flows toward the main control module through the through-flow space, and flows out of the inner cavity of the chassis through the second window.

3. The server according to claim 2, wherein in the case of the through-flow space used for flowing of the cooling fluid is disposed outside the storage module, the storage module comprises a storage adapter board and a storage, and the adapter board is located on a side that is of the storage and that is in the height direction of the chassis, and electrically connects the main control module to the storage.

4. The server according to claim 3, wherein there are a plurality of storages, the plurality of storages are spaced apart in a width direction of the chassis, and the storage module and the through-flow space are sequentially arranged in the height direction of the chassis.

5. The server according to claim 2, wherein in the case of the through-flow space used for flowing of the cooling fluid is disposed outside the first module, the first module comprises a plurality of first function cards, the plurality of first function cards are spaced apart in the height direction of the chassis, and the first module and the through-flow space are sequentially arranged in a width direction of the chassis.

6. The server according to claim 5, wherein a length direction of the first function card intersects with the length direction of the chassis.

7. The server according to claim 6, wherein an included angle between the length direction of the first function card and the width direction of the chassis is between 10° and 45°.

8. The server according to claim 7, wherein the first module comprises a first adapter board, and the first adapter board is disposed at one end of the length direction of the first function card, and electrically connects the plurality of first function cards to the main control module.

9. The server according to any one of claims 2 to 5, further comprising a fan module, wherein the fan module is closer to the first window than the main control module, the fan module comprises a fan adapter board and a fan, and the fan adapter board is disposed at one end that is of the fan and that is in the height direction of the chassis, and electrically connects the fan to the main control module.

10. The server according to any one of claims 2 to 5, wherein the second module is located on a side that is of the main control module and that is close to the second window;
the second module and the main control module are spaced apart in the width direction of the chassis; or
at least a part of the second module is located on a side that is of the main control module and that is close to the second window, and at least the part of the second module and the main control module are spaced apart in the width direction of the chassis.
